# FASCICULE DE BREVET EUROPEEN

(11) **EP 3 026 989 B1**
(45) Date de publication et mention de la délivrance du brevet: **21.03.2018**
(21) Numéro de dépôt: 15193401.5
(22) Date de dépôt: 06.11.2015
(51) Int. Cl.: H05K 7/14

(54) **BÂTI DE SUPPORT POUR AU MOINS UN ÉQUIPEMENT ÉLECTRONIQUE D'AÉRONEF, DISPOSITIF DE SUPPORT ET AÉRONEF CORRESPONDANTS**
TRAGEGESTELL FÜR MINDESTENS EINE ELEKTRONISCHE AUSRÜSTUNG EINES LUFTFAHRZEUGS, ENTSPRECHENDE GESTELLVORRICHTUNG UND ENTSPRECHENDES LUFTFAHRZEUG
SUPPORT FRAME FOR AT LEAST ONE AIRCRAFT ELECTRONIC EQUIPMENT ITEM, CORRESPONDING SUPPORT DEVICE AND AIRCRAFT

(30) Priorité: 26.11.2014 FR 1461467
(43) Date de publication de la demande: 01.06.2016
(73) Titulaire: AIRBUS OPERATIONS (S.A.S), 31060 Toulouse (FR); Airbus Operations GmbH, 21129 Hamburg (DE)
(72) Inventeur: GUIRADO, Bernard, 31600 SAUBENS (FR); DANTIN, Benoit, 93800 EPINAY-SUR-SEINE (FR); SENAC, Serge, 31600 EAUNES (FR); PEDOUSSAUT, Philippe, 31410 MAUZAC (FR); CARRERE, Sylvain, 22589 HAMBURG (DE)
(74) Mandataire: Gicquel, Olivier Yves Gérard

(56) Documents cités:
- DE-A1-102008 030 640
- FR-A1- 2 881 607
- US-A- 4 562 978
- US-A1- 2011 215 203

## Description

La présente invention concerne le domaine de l'aéronautique. Elle concerne en particulier la fixation d'équipements électroniques à la structure d'un aéronef.

Les aéronefs, et notamment les avions, comprennent de nombreux équipements électroniques. Ces équipements peuvent être répartis en de nombreuses zones de l'aéronef. Ces équipements électroniques comprennent des boitiers, contenant des composants électroniques, et qui doivent être fixés à la structure de l'aéronef. L'espace restreint à bord d'un aéronef, et les contraintes dues notamment au grand nombre d'équipements installés dans cet espace, font que la position des différents boitiers d'équipements électroniques, par rapport aux éléments de structure, est variée. Par ailleurs, les boitiers contenant les équipements électroniques présentent eux-mêmes des dimensions et des configurations variées.

En conséquence, chaque équipement électronique présent dans un aéronef est généralement fixé à la structure de l'aéronef par l'intermédiaire d'un bâti intermédiaire qui a été conçue spécialement pour cette fonction, qui peut d'une part être fixé à des points prédéterminés de la structure de l'aéronef, par l'intermédiaire d'éléments d'ancrage, et d'autre part supporter le boitier de l'équipement électronique dans une position prédéterminée par rapport à cette structure. Ce bâti intermédiaire est généralement constitué par un assemblage de nombreuses pièces. Etant conçu spécialement pour supporter un équipement électronique particulier, son prix de revient est relativement élevé. Par ailleurs, chaque équipement électronique de l'aéronef devant être monté sur un bâti intermédiaire spécifique, l'assemblage de l'aéronef nécessite un grand nombre de pièces de types différents, ce qui rend cet assemblage compliqué et couteux.

Le document DE102008030640A1 divulgue un bâti de support d'un équipement électronique d'aéronef comprenant un cadre formé de segments longitudinaux et de segments transversaux. Les segments longitudinaux servent de glissière pour l'insertion de l'équipement électronique, lequel est fixé sur le bâti de support à l'aide de systèmes de serrage prévus à une extrémité de chaque segment longitudinal.

Le document FR2881607A1 divulgue un support de fixation d'un équipement électronique comprenant un premier socle destiné à être fixé à la structure de l'aéronef ou à un rack et un support mobile adapté à la forme de l'équipement électronique.

La présente invention vise à remédier aux inconvénients de l'art antérieur.

En particulier, la présente invention a pour objectif de proposer une solution de fixation des équipements électroniques à la structure de l'aéronef qui soit plus facile à mettre en oeuvre que les solutions de l'art antérieur.

Un autre objectif de l'invention est de proposer une solution de fixation des équipements électroniques à la structure de l'aéronef qui permette de réduire le nombre de pièces de types différents utilisées pour l'assemblage de l'aéronef.

A cet effet, l'invention a pour objet un bâti de support pour au moins un équipement électronique d'aéronef qui comprend, selon l'invention :
- un cadre rectangulaire formé par quatre segments sensiblement rectilignes et présentant une surface supérieure sensiblement plane ; et
- quatre pattes présentant une surface supérieure sensiblement plane, s'étendant dans le même plan que la surface supérieure du cadre rectangulaire, chacune des pattes étant assemblée par l'une de ses extrémités à un coin du cadre, et s'étendant dans une direction formant un angle compris entre 90° et 180° avec les directions des segments du cadre formant ce coin ;
le bâti présentant un premier ensemble de trous de fixation d'au moins un équipement électronique percés dans la surface supérieure du cadre rectangulaire et/ou des pattes, et au moins un second ensemble de trous de fixation d'éléments d'ancrage à la structure de l'aéronef, percés dans une autre surface du bâti.

Un tel bâti de support permet le support d'un équipement électronique choisi parmi plusieurs équipements électroniques de types différents. Des bâtis identiques de ce type peuvent donc être utilisés pour supporter plusieurs équipements électroniques différents dans l'aéronef.

Selon un mode de réalisation avantageux, au moins deux des segments du cadre, parallèles entre eux, sont formés chacun par deux branches de segment de cadre, reliées chacune à l'une des pattes et assemblées l'une à l'autre.

Les dimensions du cadre peuvent ainsi être modifiées, en fonction de la position relative des branches quand elles sont assemblées.

Avantageusement, dans ce cas, les deux branches formant chacun desdits segments de cadre sont assemblées l'une à l'autre par une liaison glissière et par des moyens de blocage du coulissement de ladite liaison glissière.

Selon un autre mode de réalisation possible, le cadre et les pattes forment un ensemble monobloc.

L'invention concerne également un dispositif de support pour au moins un équipement électronique d'aéronef, comprenant :
- au moins un bâti tel que décrit ci-dessus ; et
- au moins un éléments d'ancrage à la structure de l'aéronef;
les éléments d'ancrage étant fixés au bâti par l'intermédiaire de moyens de fixation traversant des trous du second ensemble de trous du bâti.

Selon un mode de réalisation avantageux, le dispositif de support comprend au moins deux bâtis identiques, tels que décrits ci-dessus, solidarisés l'un à l'autre dans une position telle que les surfaces supérieures des cadres des bâtis s'étendent dans le même plan.

Ce dispositif permet alors le support de plusieurs équipements électroniques, ou d'un équipement unique de taille trop importante pour être supporté par un bâti unique.

Selon un mode de réalisation avantageux, le dispositif de support comprend au moins deux bâtis identiques, tels que décrits ci-dessus, solidarisés l'un à l'autre par l'intermédiaire d'au moins deux entretoises, dans une position telle que les surfaces supérieures des cadres desdits bâtis s'étendent dans des plans parallèles.

L'invention concerne également un aéronef, comprenant au moins deux équipements électroniques différents assemblés chacun à la structure de l'aéronef par l'intermédiaire d'un dispositif de support tel que décrit ci-dessus, les différents dispositifs de support mettant en oeuvre des bâtis identiques.

D'autres caractéristiques et avantages ressortiront de la description qui va suivre de l'invention, description donnée à titre d'exemple uniquement, en regard des dessins annexés sur lesquels :
- la figure 1 est une vue d'un bâti de support pour un équipement électronique d'aéronef selon un premier mode de réalisation de l'invention ;
- la figure 2 est une vue d'un bâti de support pour un équipement électronique d'aéronef selon un second mode de réalisation de l'invention, dans une première position d'utilisation ;
- la figure 3 est une vue du bâti de support de la figure 2, dans une seconde position d'utilisation ;
- la figure 4 est une vue du bâti de support de la figure 2, dans une troisième position d'utilisation ;
- la figure 5 est une section d'un segment du bâti de support de la figure 2 ;
- la figure 6 est une vue du bâti de support de la figure 1 sur lequel est monté un équipement électronique ;
- la figure 7 représente un premier mode de réalisation de dispositif de support pour un équipement électronique d'aéronef selon l'invention, mettant en oeuvre le bâti représenté par la figure 1 ;
- la figure 8 représente une bielle mise en oeuvre dans le dispositif de support de la figure 7 ;
- la figure 9 représente une patte d'ancrage mise en oeuvre dans le dispositif de support de la figure 7 ;
- la figure 10 représente le dispositif de support de la figure 7 assemblé à la structure d'un aéronef;
- la figure 11 représente un second mode de réalisation de dispositif de support pour au moins un équipement électronique d'aéronef selon l'invention, mettant en oeuvre deux bâtis ;
- la figure 12 représente les deux bâtis mis en oeuvre dans le dispositif de support de la figure 11 ;
- la figure 13 représente un troisième mode de réalisation de dispositif de support pour deux équipements électroniques d'aéronef selon l'invention, mettant en oeuvre deux bâtis ;
- la figure 14 représente les deux bâtis mis en oeuvre dans le dispositif de support de la figure 13, assemblés par des entretoises ;
- la figure 15 représente le bâti de la figure 1 sur lequel sont assemblés deux équipements électroniques ; et
- la figure 16 représente le bâti de la figure 1 sur lequel est assemblé un équipement électronique.

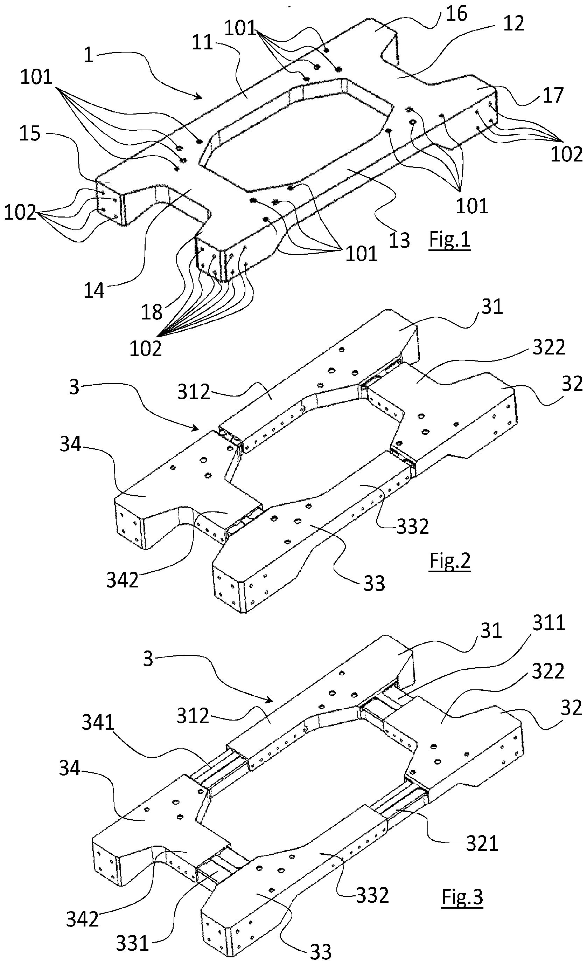

La figure 1 représente un bâti 1 selon un premier mode de réalisation de l'invention, permettant le support et la fixation d'un équipement électronique dans un aéronef.

Ce bâti 1 est composé d'un cadre rectangulaire formé par quatre segments sensiblement rectilignes 11, 12, 13 et 14, et de quatre pattes 15, 16, 17 et 18 s'étendant à partir des quatre coins du cadre. Le cadre et les pattes s'étendent sensiblement dans le même plan, de façon à offrir une surface supérieure de support sensiblement plane. Chacune des quatre pattes s'étend dans une direction formant un angle compris entre 90° et 180° avec les directions des deux segments du cadre formant le coin du cadre où elle est fixée. Dans le mode de réalisation représenté, ces pattes sont orientées dans l'alignement des segments 11 et 13, les plus longs du cadre rectangulaire.

Le bâti 1 présente un ensemble de trous 101 percés dans les segments 11, 12, 13 et 14 du cadre et/ou dans les pattes 15, 16, 17 et 18, dans une direction sensiblement perpendiculaire au plan défini par la surface supérieure de support. Ces trous 101 (par soucis de clarté, les trous 101 ne sont référencés que sur la figure 1) sont destinés à recevoir des moyens de fixation, de type vis ou boulons, permettant la fixation des boitiers des équipements électroniques de l'aéronef. La forme particulière du bâti 1 permet que les trous 101 soient répartis de telle sorte que des trous 101 soient placés en regard des positions des moyens de fixations des boitiers d'équipements électroniques, pour la plupart des équipements électroniques utilisés sur un aéronef.

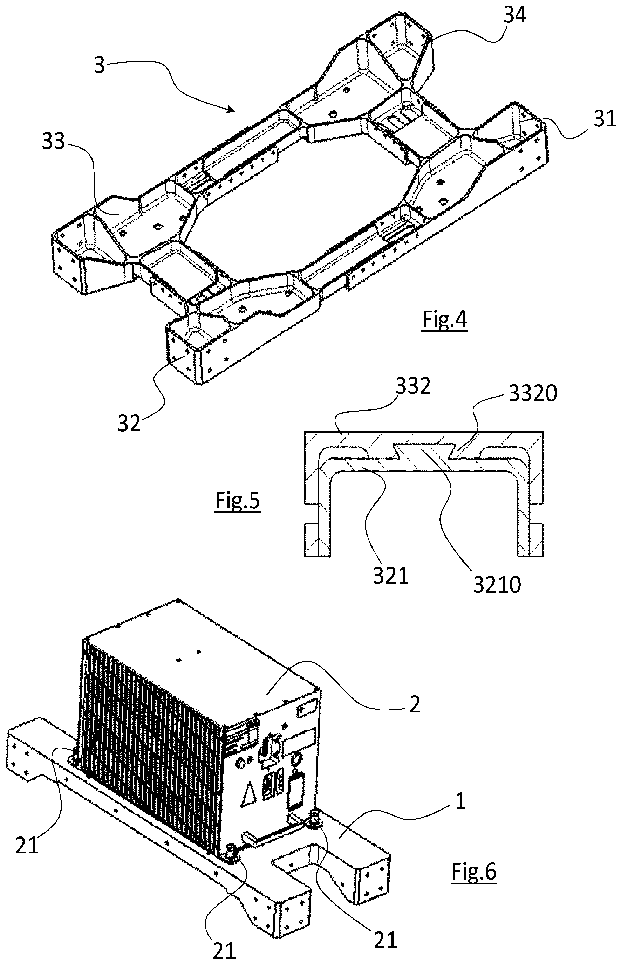

Ainsi, la figure 6 représente le bâti 1 supportant le boitier 2 d'un équipement électronique, qui est placé sur la face supérieure plane du bâti 1, et y est fixé par des boulons 21 passant par des trous 101 du bâti 1 et par des trous ménagés dans des pattes de fixation du boitier 2. Ainsi, la pluralité de trous 101 permet la fixation sur le bâti 1 d'un équipement électronique quelconque parmi une pluralité d'équipements électroniques ayant des boitiers de tailles différentes, qui doivent être installés dans l'aéronef. Ce même bâti 1 peut donc être utilisé dans les dispositifs de support dans l'aéronef d'un grand nombre d'équipements électroniques différents. Il est ainsi possible, en utilisant le bâti 1 pour le montage d'un grand nombre d'équipements électroniques différents, de limiter considérablement la diversité des pièces utilisées pour la fabrication de l'aéronef. Ce bâti permet donc de réduire le stock de pièces nécessaire pour l'assemblage de l'aéronef. Par ailleurs, de nombreux bâtis identiques étant utilisés dans chaque aéronef, il est possible de les fabriquer en série plus grande que les bâtis de l'art antérieurs, qui n'étaient adaptés qu'à un type d'équipement électronique. Leur cout de fabrication peut en conséquence être mieux maitrisé.

Le bâti 1 présente également des ensembles de trous 102 percés dans des surfaces des quatre pattes 15, 16, 17 et 18, sensiblement perpendiculairement au plan défini par la surface supérieure de support (par soucis de clarté, les trous 102 ne sont référencés que sur la figure 1). Ces trous 102 sont destinés à recevoir des moyens de fixation, comme des vis, des boulons ou des rivets, permettant la fixation au bâti 1 d'éléments d'ancrage du bâti 1 à la structure de l'aéronef.

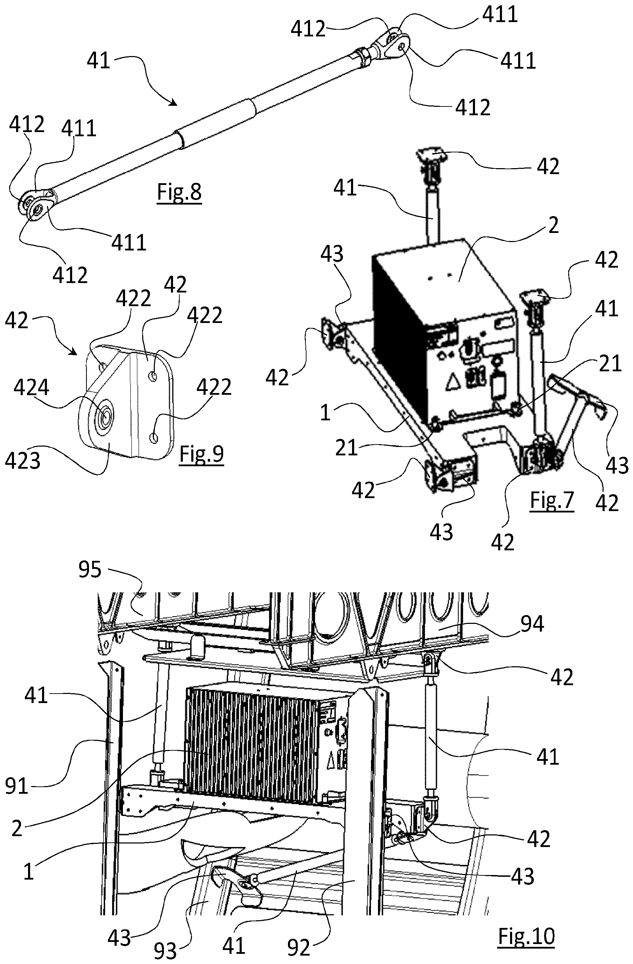

La figure 7 représente un dispositif de support pour un équipement électronique d'aéronef mettant en oeuvre le bâti 1 représenté par la figure 1. Ce bâti 1 supporte le boitier 2 d'un équipement électronique, qui est fixé sur la face supérieure plane du bâti 1 par des boulons 21 passant par des trous 101 du bâti 1.

Ce dispositif de support comporte également des éléments d'ancrage permettant sa fixation à la structure de l'avion. Ces éléments d'ancrage comprennent notamment des bielles 41 de longueurs réglables, telles que celle représentée par la figure 8, et des pattes d'ancrage telles que la patte d'ancrage 42 représentée par la figure 9. Les bielles 41 présentent, à chacune de leurs extrémités, deux flancs parallèles 411 présentant des trous alignés 412 permettant de passer une tige de fixation. Les pattes d'ancrage 42 présentent un socle 421 dans lequel sont prévus quatre perçages 422 de passage de vis, et un corps 423 dans lequel est prévu un trou 424 de passage d'une tige de fixation. Ce trou peut être un trou simple ou peut être prévu dans une rotule portée par le corps 423.

Des pattes d'ancrage 42 sont fixées au bâti 1 par l'intermédiaire de vis traversant les perçages 422 de la patte d'ancrage 42 et les trous 102 du bâtis. D'autres pattes d'ancrage 43 de modèles différents peuvent être fixées au bâti par l'intermédiaire d'autres trous 102 du bâtis.

Ces pattes d'ancrage peuvent être connectées aux premières extrémités de bielles 41, par l'intermédiaire de tiges de fixation traversant les trous 412 des bielles et les trous 424 des pattes d'ancrage. Dans ce cas, la seconde extrémité de chaque bielle peut être connectée à une seconde patte d'ancrage 42 ou 43, qui peut elle-même être fixée à la structure de l'aéronef. La longueur des bielles 41 peut être réglable, grâce à un système de vis bien connu de l'homme du métier. Une patte d'ancrage 43 fixée au bâti 1 peut également être directement connectée à une patte d'ancrage 42 complémentaire, qui peut elle-même être fixée à la structure de l'aéronef.

Ainsi, les éléments d'ancrage constitués notamment par les pattes d'ancrage 42, 43, 44 et les bielles 41 permettent de fixer facilement le dispositif de support à la structure de l'aéronef, au niveau de points de cette structure qui sont proches du bâti 1 ou de points plus éloignés de ce bâti 1. La figure 10 représente ainsi le dispositif de support de la figure 7 assemblé à des éléments de structure d'un aéronef. Ce dispositif est assemblé, par l'intermédiaire de pattes d'ancrage 42 et 43 à des poutres verticales 91 et 92 passant à proximité du bâti 1, et également par l'intermédiaire d'assemblages de bielles 41 et de pattes d'ancrages 42 et 43, à des poutres 93, 94 et 95 éloignées de ce bâti 1.

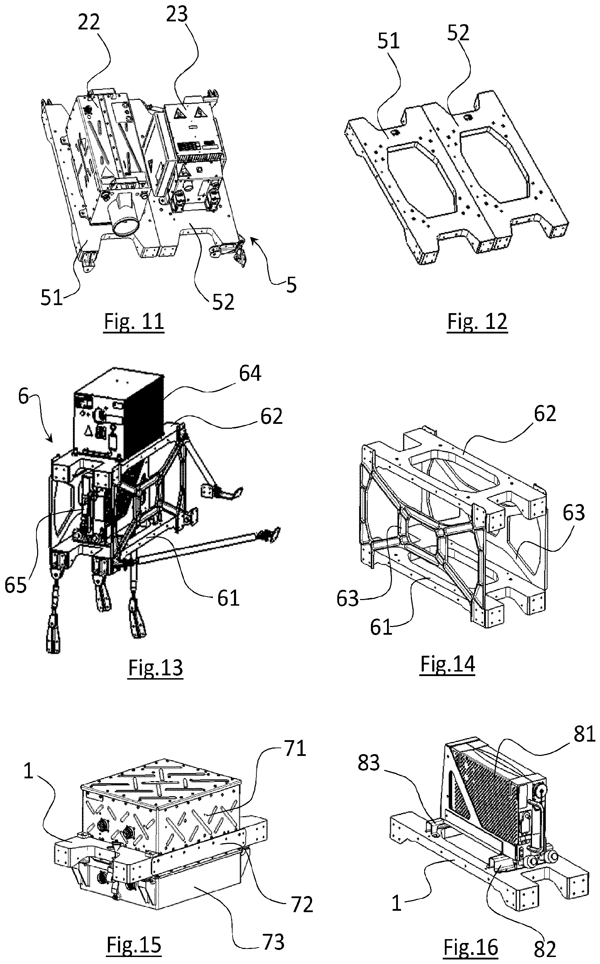

La figure 11 représente un dispositif de support pour au moins un équipement électronique d'aéronef selon un autre mode de réalisation de l'invention. Ce dispositif de support 5 met en oeuvre deux bâtis 51 et 52, identiques au bâti 1 représenté par la figure 1. Ces deux bâtis, qui sont représentés par la figure 12, sont assemblés l'un à l'autre par des éléments de liaison tels que des boulons ou des rivets passant par des trous 102 des bâtis. Cet assemblage des bâtis est fait de telle sorte que les surfaces supérieures de support des deux bâtis se trouvent dans le même plan.

Le dispositif de support ainsi créé permet d'offrir une grande surface de support, composée des surfaces supérieures de support des deux bâtis 51 et 52, pour supporter plusieurs boitiers 22 et 23 d'équipements électroniques, ou un boitier de grande taille.

Ce dispositif de support 5 comporte également des éléments d'ancrage, semblables à ceux décrits précédemment, permettant d'assembler les deux bâtis 51 et 52 à la structure de l'avion.

La figure 13 représente un dispositif de support de deux équipements électroniques d'aéronef selon un autre mode de réalisation de l'invention. Ce dispositif de support 6 met en oeuvre deux bâtis 61 et 62, identiques au bâti 1 représenté par la figure 1. Ces deux bâtis, qui sont représentés par la figure 14, sont maintenus l'un au-dessus de l'autre par deux entretoises latérales 63, de telle sorte que leurs faces supérieures s'étendent dans des plans sensiblement parallèles.

Les entretoises latérales 63 sont assemblées par des éléments de liaison tels que des boulons ou des rivets passant par des trous 102 des bâtis. Le dispositif de support ainsi créé permet de supporter plusieurs boitiers 64 et 65 d'équipement électronique. Ce dispositif de support comporte également des éléments d'ancrage, semblables à ceux décrits précédemment, permettant de l'assembler à la structure de l'avion.

Les figures 2 à 5 représentent un bâti modulaire 3 selon un autre mode de réalisation possible de l'invention. Ce bâti présente, comme le bâti 1, un cadre rectangulaire formé par quatre segments sensiblement rectilignes, et quatre pattes assemblées aux quatre coins du cadre. Comme le bâti 1, il présente une surface supérieure destinée à recevoir un équipement électronique et percée de trous 101 (non référencés sur les figures 2 à 5), et ses bords latéraux sont percés de trous 102 (non référencés sur les figures 2 à 5).

Cependant, contrairement au mode de réalisation représenté à la figure 1, ce bâti n'est pas formé d'un seul bloc. Au contraire, le bâti 3 est composé de quatre portions de bâti 31, 32, 33 et 34, qui forment chacune une patte reliée à deux branches de segments de cadre. Plus précisément, chacune de ces portions de bâti 31, 32, 33 et 34 comporte une première branche de segment de cadre, respectivement 311, 321, 331 et 341, qui présente une forme extérieure conformée en coulisseau male, et une seconde branche de segment de cadre, respectivement 312, 322, 332 et 342, qui présente une forme interne conformée en glissière femelle.

Chaque première branche présente une forme complémentaire d'une seconde branche d'une autre portion de bâti, pour assurer une liaison glissière-coulisseau entre deux portions de bâti. Comme le montre la figure 5, qui représente une section transversale de la première branche 321 de la portion de bâti 32 et de la seconde branche 332 de la portion de bâti 33, la liaison glissière-coulisseau peut être assurée par un assemblage à queue d'aronde entre ces deux branches, la première branche 321 présentant une forme de queue d'aronde male 3210 et la seconde branche 332 présentant une forme de queue d'aronde femelle 3320. Ainsi les quatre portions de bâti 31, 32, 33 et 34 peuvent s'assembler par des liaisons glissière-coulisseau pour former le cadre du bâti 3.

Les liaisons glissière-coulisseau permettant la translation des portions de bâti les uns par rapport aux autres, le cadre du bâti 3 peut prendre plusieurs configurations dans lesquelles il présente des dimensions différentes. La position des portions de bâti peut être bloquée par des vis de blocage, de telle sorte que le bâti 3 devienne rigide, avec un cadre présentant les dimensions souhaitées.

Le bâti 3 peut ainsi être modifié très facilement pour que ses dimensions soient adaptées aux dimensions de l'équipement électronique qu'il doit supporter. Il est ainsi très facile de modifier la longueur et/ou la largeur de ce bâti 3 pour lui permettre de recevoir un équipement électronique de taille donnée. Cette modification peut également permettre de faire coïncider la position des trous 101 de ce bâti avec la position des points de fixation de l'équipement électronique. Un tel bâti modulaire 3 de dimension réglable peut être mis en oeuvre dans les mêmes conditions que le bâti modulaire 1 présenté précédemment. Il peut ainsi être mis en oeuvre dans tous les dispositifs de supports décrits dans la présente demande de brevet, en remplacement du bâti modulaire 1.

Bien évidemment, des variantes de ce bâti 3 peuvent être mis en oeuvre par l'homme du métier. Il est ainsi possible, par exemple, que seules deux des segments de cadres, parallèles entre eux, soient composés chacun de deux branches assemblées l'une à l'autre. Dans ce cas, les dimensions du bâti ne peuvent être modifiées que dans une direction. D'autre types d'assemblage des branches de bâti entre elles peuvent également être mises en oeuvre. Un tel assemblage peut par exemple être réalisé par l'intermédiaire d'entretoise. Dans ce cas, le choix de la longueur de l'entretoise permet de déterminer les dimensions du bâti.

La figure 4 présente une vue de dessous du bâti 3. Comme le montre cette figure, ce bâti est une structure creuse, préférentiellement obtenue par fonderie ou usinage d'aluminium. Il est à noter que, de façon avantageuse, les portions de bâti 31 et 33 sont identiques, de même que les portions 32 et 34. Il est ainsi possible de fabriquer le bâti 3 avec un nombre réduit de références de pièces.

L'homme du métier pourra facilement imaginer d'autres modes de réalisation possibles de l'invention, permettant de fabriquer des dispositifs de support adaptés pour installer des équipements électroniques de modèles différents, à différents endroits de l'aéronef, en utilisant un bâti standardisé.

Différentes variantes de fixation des équipements électroniques au bâti peuvent être imaginées par l'homme du métier. Ainsi, la figure 15 représente un bâti 1 sur lequel est monté un premier équipement électronique 71. Une structure de support 72, fixée par des vis sur les bords latéraux du bâti 1, permet de suspendre un second équipement électronique 73 en dessous de ce bâti 1. La figure 16 représente un bâti 1 sur lequel un équipement électronique 81 est fixé par l'intermédiaire d'entretoises 82 et 83, elles-mêmes fixées à la face supérieure du bâti 1.

L'invention concerne également un aéronef comprenant au moins deux équipements électroniques différents, chacun de ces équipements électroniques étant assemblé à la structure de l'aéronef par l'intermédiaire d'un bâti identique selon l'un des mode de réalisation de l'invention, certains des trous du bâti étant utilisé pour le passage de moyens de fixation du boitier au bâti, et d'autres trous de fixation étant utilisés pour le passage de moyens de fixation du bâti à la structure de l'avion.

## Revendications

1. Bâti de support d'au moins un équipement électronique d'aéronef, **caractérisé en ce qu'**il comprend :
- un cadre rectangulaire formé par quatre segments (11, 12, 13, 14) sensiblement rectilignes et présentant une surface supérieure sensiblement plane; et
- quatre pattes (15, 16, 17, 18) présentant une surface supérieure sensiblement plane, s'étendant dans le même plan que la surface supérieure dudit cadre rectangulaire, chacune desdites pattes (15, 16, 17, 18) étant assemblée par l'une de ses extrémités à un coin dudit cadre, et s'étendant dans une direction formant un angle compris entre 90° et 180° avec les directions des segments (11, 12, 13, 14) dudit cadre formant ledit coin du cadre ;
ledit bâti (1, 3, 51, 52, 61, 62) présentant un premier ensemble de trous de fixation (101) d'au moins un équipement électronique (2, 55, 64, 65) percés dans ladite surface supérieure dudit cadre rectangulaire et/ou desdites pattes, et au moins un second ensemble de trous de fixation (102) d'éléments d'ancrage (41, 42, 43) à la structure de l'aéronef, percés dans une autre surface du bâti.

2. Bâti selon la revendication 1, **caractérisé en ce qu'**au moins deux desdits segments dudit cadre, parallèles entre eux, sont formés chacun par deux branches de segment de cadre, reliées chacune à l'une desdites pattes et assemblées l'une à l'autre.

3. Bâti selon la revendication 2, **caractérisé en ce que** les deux branches formant chacun desdits segments de cadre sont assemblées l'une à l'autre par une liaison glissière et par des moyens de blocage du coulissement de ladite liaison glissière.

4. Bâti selon la revendication 1, **caractérisé en ce que** ledit cadre et lesdites pattes forment un ensemble monobloc.

5. Dispositif de support d'au moins un équipement électronique d'aéronef, **caractérisé en ce qu'**il comprend :
- au moins un bâti (1, 3, 51, 52, 61, 62) selon l'une quelconque des revendications 1 à 4 ; et
- au moins un éléments d'ancrage (41,42,43) à la structure de l'aéronef ;
lesdits éléments d'ancrage (41, 42, 43) étant fixés audit bâti (1) par l'intermédiaire de moyens de fixation traversant des trous (102) dudit second ensemble de trous du bâti (1).

6. Dispositif de support selon la revendication 5, **caractérisé en ce qu'**il comprend au moins deux bâtis identiques (51, 52), selon l'une quelconque des revendications 1 à 3, solidarisés l'un à l'autre dans une position telle que les surfaces supérieures des cadres desdits bâtis (51, 52) s'étendent dans le même plan.

7. Dispositif de support selon la revendication 5, **caractérisé en ce qu'**il comprend au moins deux bâtis identiques (61, 62), selon l'une quelconque des revendications 1 à 3, solidarisés l'un à l'autre par l'intermédiaire d'au moins deux entretoises, dans une position telle que les surfaces supérieures des cadres desdits bâtis s'étendent dans des plans parallèles.

8. Aéronef, **caractérisé en ce qu'**il comprend au moins deux équipements électroniques différents assemblés chacun à la structure de l'aéronef par l'intermédiaire d'un dispositif de support selon l'une quelconque des revendications 5 à 8, les différents dispositifs de support mettant en oeuvre des bâtis (1, 3, 51, 52, 61, 62) identiques.

## Patentansprüche

1. Traggestell mindestens einer elektronischen Ausrüstung eines Luftfahrzeugs, **dadurch gekennzeichnet, dass** es enthält:
- einen rechtwinkligen Rahmen, der von vier Segmenten (11, 12, 13, 14) gebildet wird, die im Wesentlichen geradlinig sind und eine im Wesentlichen ebene Oberfläche aufweisen; und
- vier Lappen (15, 16, 17, 18), die eine im Wesentlichen ebene Oberfläche aufweisen, die sich in der gleichen Ebene wie die Oberfläche des rechtwinkligen Rahmens erstreckt, wobei jeder der Lappen (15, 16, 17, 18) durch eines seiner Enden mit einer Ecke des Rahmens zusammengebaut ist und sich in einer Richtung erstreckt, die einen Winkel zwischen 90° und 180° mit den Richtungen der Segmente (11, 12, 13, 14) des Rahmens bildet, die die Ecke des Rahmens bilden;
wobei das Gestell (1, 3, 51, 52, 61, 62) eine erste Gruppe von Befestigungslöchern (101) mindestens einer elektronischen Ausrüstung (2, 55, 64, 65), die in die Oberfläche des rechtwinkligen Rahmens und/oder der Lappen gebohrt sind, und mindestens eine zweite Gruppe von Befestigungslöchern (102) von Verankerungselementen (41, 42, 43) an der Struktur des Luftfahrzeugs aufweist, die in eine andere Fläche des Gestells gebohrt sind.

2. Gestell nach Anspruch 1, **dadurch gekennzeichnet, dass** mindestens zwei zueinander parallele Segmente des Rahmens je von zwei Rahmensegmentzweigen gebildet werden, die je mit einem der Lappen verbunden und aneinandergefügt sind.

3. Gestell nach Anspruch 2, **dadurch gekennzeichnet, dass** die jedes der zwei Rahmensegmente bildenden zwei Zweige durch eine Gleitschienenverbindung und durch Gleitblockiereinrichtungen der Gleitschienenverbindung aneinandergefügt sind.

4. Gestell nach Anspruch 1, **dadurch gekennzeichnet, dass** der Rahmen und die Lappen eine einstückige Einheit bilden.

5. Tragvorrichtung mindestens einer elektronischen Ausrüstung eines Luftfahrzeugs, **dadurch gekennzeichnet, dass** sie enthält:
- mindestens ein Gestell (1, 3, 51, 52, 61, 62) nach einem der Ansprüche 1 bis 4; und
- mindestens ein Verankerungselement (41, 42, 43) an der Struktur des Luftfahrzeugs;
wobei die Verankerungselemente (41, 42, 43) mittels Befestigungseinrichtungen am Gestell (1) befestigt sind, die Löcher (102) der zweiten Gruppe von Löchern des Gestells (1) durchqueren.

6. Tragvorrichtung nach Anspruch 5, **dadurch gekennzeichnet, dass** sie mindestens zwei gleiche Gestelle (51, 52), nach einem der Ansprüche 1 bis 3 enthält, die in einer derartigen Stellung, dass die Oberflächen der Rahmen der Gestelle (51, 52) sich in der gleichen Ebene erstrecken, fest miteinander verbunden sind.

7. Tragvorrichtung nach Anspruch 5, **dadurch gekennzeichnet, dass** sie mindestens zwei gleiche Gestelle (61, 62) nach einem der Ansprüche 1 bis 3 enthält, die mittels mindestens zweier Abstandshalter in einer solchen Stellung fest miteinander verbunden sind, dass die Oberflächen der Rahmen der Gestelle sich in parallelen Ebenen erstrecken.

8. Luftfahrzeug, **dadurch gekennzeichnet, dass** es mindestens zwei unterschiedliche elektronische Ausrüstungen enthält, die je an die Struktur des Luftfahrzeugs mittels einer Tragvorrichtung nach einem der Ansprüche 5 bis 8 angefügt sind, wobei die verschiedenen Tragvorrichtungen gleiche Gestelle (1, 3, 51, 52, 61, 62) verwenden.

## Claims

1. Support rack for at least one item of aircraft electronics, **characterized in that** it comprises:
- a rectangular frame formed by four essentially straight segments (11, 12, 13, 14) and having an essentially planar upper surface; and
- four feet (15, 16, 17, 18) having an essentially planar upper surface, extending in the same plane as the upper surface of said rectangular frame, each of said feet (15, 16, 17, 18) being joined via one of its ends to a corner of said frame, and extending in a direction forming an angle between 90° and 180° with the directions of the segments (11, 12, 13, 14) of said frame forming said corner of the frame;
said rack (1, 3, 51, 52, 61, 62) having a first set of holes (101) for attaching at least one item of electronic equipment (2, 55, 64, 65), which are made in said upper surface of said rectangular frame and/or of said feet, and at least one second set of attachment holes (102) for elements (41, 42, 43) for anchoring to the structure of the aircraft, which are made in another surface of the rack.

2. Rack according to Claim 1, **characterized in that** at least two of said segments of said frame, which are mutually parallel, are each formed by two branches of a frame segment, each connected to one of said feet and joined to one another.

3. Rack according to Claim 2, **characterized in that** the two branches forming each of said frame segments are joined to one another by a sliding connection and by means for blocking the sliding of said sliding connection.

4. Rack according to Claim 1, **characterized in that** said frame and said feet form a one-piece assembly.

5. Device for supporting at least one item of aircraft electronics, **characterized in that** it comprises:
- at least one rack (1, 3, 51, 52, 61, 62) according to any one of claims 1 to 4; and
- at least one element (s) (41, 42, 43) for anchoring to the structure of the aircraft;
said anchoring element(s) (41, 42, 43) being attached to said rack (1) via the intermediary of attachment means passing through holes (102) of said second set of holes of the rack (1).

6. Support device according to Claim 5, **characterized in that** it comprises at least two identical racks (51, 52), according to any one of claims 1 to 3, secured to one another in such a position that the upper surfaces of the frames of said racks (51, 52) extend in the same plane.

7. Support device according to Claim 5, **characterized in that** it comprises at least two identical racks (61, 62), according to any one of Claims 1 to 3, secured to one another via the intermediary of at least two spacers, in such a position that the upper surfaces of the frames of said racks extend in parallel planes.

8. Aircraft, **characterized in that** it comprises at least two different items of electronic equipment each joined to the structure of the aircraft via the intermediary of a support device according to any one of Claims 5 to 8, the various support devices employing identical racks (1, 3, 51, 52, 61, 62).
